# EUROPEAN PATENT SPECIFICATION

(11) **EP 3 857 602 B1**
(45) Date of publication and mention of the grant of the patent: **23.08.2023**
(21) Application number: 20745659.1
(22) Date of filing: 22.01.2020
(51) Int. Cl.: H01L 27/15, H01L 27/12, H01L 33/36, H01L 33/62, H01L 33/00, H01L 21/306, H01L 25/075, H01L 25/16

(54) **DISPLAY MODULE AND REPAIRING METHOD OF THE SAME**
ANZEIGEMODUL UND REPARATURVERFAHREN DAFÜR
MODULE D'AFFICHAGE ET SON PROCÉDÉ DE RÉPARATION

(30) Priority: 22.01.2019 KR 20190007902; 17.01.2020 KR 20200006408
(43) Date of publication of application: 04.08.2021
(73) Proprietor: Samsung Electronics Co., Ltd., Suwon-Si, Gyeonggi-do 16677 (KR)
(72) Inventor: SHIN, Sangmin, Suwon-si, Gyeonggi-do 16677 (KR); KIM, Jinho, Suwon-si, Gyeonggi-do 16677 (KR); JUNG, Youngki, Suwon-si, Gyeonggi-do 16677 (KR); JO, Youngkyong, Suwon-si, Gyeonggi-do 16677 (KR)
(74) Representative: Appleyard Lees IP LLP
(86) International application number: PCT/KR2020/001127
(87) International publication number: WO 2020/153767

(56) References cited:
- EP-A2- 3 343 273
- US-A1- 2016 351 092
- US-A1- 2017 338 211
- US-A1- 2018 012 876
- US-A1- 2018 019 369
- US-A1- 2018 159 088
- US-A1- 2018 159 088
- US-A1- 2018 226 388
- US-B1- 10 043 788

## Description

### [Technical Field]

The disclosure relates to a display module, and more particularly, to a display module capable of effectively repairing a defective light emitting diode (LED) mounted thereon, and a repairing method of the same.

### [Background Art]

A light emitting diode (LED) is widely used as a light source not only for a lighting device but also for various display devices of various electronic products such as television (TV), mobile phone, desktop personal computer (PC), laptop PC, personal digital assistant (PDA), etc.

In particular, a micro LED having a size of 100 µm or less is recently developed. This micro LED has faster response speed, requires lower power and has higher luminance than a conventional LED, and is thus spotlighted as a light emitting element of a next generation display.

The display module may be manufactured by chip processing, transferring and bonding an LED wafer.

In this case, the LED may have a defect in epitaxial process, chip process, transfer process or bonding process. Such a defect may later cause a dead pixel or a defective pixel.

For example, the defective pixel may have its LED failing to emit light even though power is applied to the display module (this may be referred to as an off-dot defect). Alternatively, the defective pixel may have its LED emitting light even though no power is applied to the display module (this may be referred to as an on-dot defect).

Therefore, there is a need for a display module capable of repairing such a pixel having the off-dot or on-dot defect and a repairing method of the same.

EP 3 343 273 A2 describes a display device and a multi-screen display device using the same, which include a minimized bezel area. US 10 043 788 B 1 describes a micro light emitting diode display panel and a repair method thereof. US 2018/159088 A1 describes a display including a back plat, a plurality of light emitting devices and a plurality of light compensating devices.

### [Disclosure of Invention]

### [Technical Problem]

Provided are a display module having a structure capable of repairing a defective pixel and a repairing method of the same.

Additional aspects will be set forth in part in the description which follows and, in part, will be apparent from the description, or may be learned by practice of the presented embodiments.

### [Technical Solution]

In accordance with an aspect of the disclosure, a display module includes a glass substrate on which a thin film transistor (TFT) is formed; and a sub-pixel disposed on the TFT, wherein the TFT includes: a first electrode; a second electrode spaced apart from the first electrode; a source pad spaced part from the second electrode in a perpendicular direction and electrically connected to the second electrode; and a gate pad disposed below the source pad, wherein the sub-pixel includes a light emitting diode (LED), wherein the LED is connected to the first electrode and the second electrode, and wherein the source pad is extended toward the second electrode beyond the first electrode facing a space between the first electrode and the second electrode in an upward direction, and facing a portion of the gate pad in a downward direction.

The sub-pixel may include: a first region on which a first LED is mounted, and a second region formed adjacent to the first region, and on which a second LED is mounted, and the first electrode and the second electrode may be disposed over the first region and the first electrode and the second electrode may be disposed over the second region.

The sub-pixel may further include a sacrificial layer covering the second region.

The sub-pixel may further include at least one slit disposed between the first electrode and the second electrode, and the sacrificial layer may cover a portion of the at least one slit.

The at least one slit may include a first slit spaced apart from a second slit.

The display module may further include a sacrificial layer disposed in a band shape along an edge of the second region on which the second LED is mounted.

Based on the first LED of the sub-pixel emitting light when zero voltage is applied to the first LED, the gate pad corresponding to the first LED may be connected with the source pad by laser welding, and the source pad may be disconnected from the metal pad using a laser beam.

In accordance with an aspect of the disclosure, a repairing method of a display module includes detecting a defective sub-pixel in a display module; connecting a gate pad of a thin film transistor (TFT) corresponding to the detected defective sub-pixel to a source pad; and preventing a source voltage from being applied to the source pad by cutting a metal pad connected to the source pad.

The method may further include welding the gate pad to the source pad using a laser beam.

The metal pad may be cut using a laser beam.

In accordance with an aspect of the disclosure, present in the dependent claims, a display module includes a glass substrate on which a plurality of thin film transistors (TFTs) are formed; and a plurality of pixels including a plurality of sub-pixels arranged on the plurality of TFTs, wherein each sub-pixel of the plurality of sub-pixels includes: a first region on which a first light emitting diode (LED) is mounted; a second region formed adjacent to the first region and on which a second LED is mounted; and a sacrificial layer covering the second region.

Each TFT of the plurality of TFTs may include a first electrode and a second electrode connected to the first LED and the second LED, and the each sub-pixel of the plurality of sub-pixels further may include a slit disposed along an edge of the second region between the first electrode and the second electrode.

The sacrificial layer may cover the first electrode, the second electrode and a portion of the slit.

The slit may be disposed on a same plane as the first electrode and the second electrode.

The each TFT of the plurality of TFTs may include a metal pad disposed below the first electrode, and the metal pad may be extended to face the slit.

### [Advantageous Effects]

The repairing method according to an embodiment is advantageous than replacing the defective LED in terms of cost.

The repairing method according to an embodiment is easy to repair the on-dot defective LED.

### [Brief Description of Drawings]

The above and other aspects, features, and advantages of certain embodiments of the present disclosure will be more apparent from the following description taken in conjunction with the accompanying drawings, in which:
FIG. 1 is a plan view schematically illustrating a display module according to an embodiment;
FIG. 2 is a plan view schematically illustrating a pixel according to an embodiment;
FIG. 3 is a cross-sectional view taken along line 'III-III' of FIG. 2;
FIG. 4A is a cross-sectional view taken along line 'A-A' of FIG. 2;
FIG. 4B is a cross-sectional view taken along line 'B-B' of FIG. 2;
FIG. 5 is a plan view schematically illustrating a pixel according to another embodiment;
FIG. 6 is a cross-sectional view taken along line 'VI-VI' of FIG. 5;
FIG. 7 is a plan view schematically illustrating a pixel according to still another embodiment;
FIG. 8 is a flowchart illustrating a repairing method of a display module according to an embodiment;
FIGS. 9A, 9B, 10A, 10B, 11A, 11B, 12A and 12B are views for describing a repairing method of a display module according to an embodiment;
FIG. 13 is a cross-sectional view of a thin film transistor (TFT) taken along the line 'A-A' of FIG. 2;
FIG. 14 is a cross-sectional view illustrating that a defective sub-pixel is repaired according to an embodiment;
FIG. 15 is a cross-sectional view of a TFT taken along the line 'B-B' of FIG. 2; and
FIG. 16 is a flowchart illustrating a repairing method of a display module according to an embodiment.

### [Best Mode for Carrying out the Invention]

To sufficiently understood configurations and effects of the disclosure, embodiments are described with reference to the accompanying drawings. However, the disclosure is not limited to exemplary embodiments to be described below, but may be implemented in several forms and may be variously modified. A description for these embodiments is provided only to make the disclosure complete and allow those skilled in the art to which the disclosure pertains to completely recognize the scope of the disclosure. In the accompanying drawings, sizes of components may be enlarged as compared with actual sizes for convenience of explanation, and ratios of the respective components may be exaggerated or reduced.

Terms used in the specification, 'first', 'second' and the like may be used to describe various components, and the components are not to be interpreted to be limited to the terms. These terms may be used to differentiate one component from other components. For example, a 'first' component may be named a 'second' component and the 'second' component may also be similarly named the 'first' component, without departing from the scope of the disclosure.

Singular forms are intended to include plural forms unless the context clearly indicates otherwise. It may be interpreted that terms "include", "have" or the like specify the presences of features, numerals, steps, operations, components and parts mentioned in the specification or a combination thereof, but do not preclude the addition of one or more other features, numerals, steps, operations, components, parts or a combination thereof.

Terms used in embodiments may be interpreted as the same meanings as meanings that are generally known to those skilled in the art unless defined otherwise.

A display module manufactured according to embodiments may include: a substrate on a surface of which a thin film transistor (TFT) layer is formed; a plurality of light emitting diodes (LEDs) arranged on the TFT layer; and wiring electrically connecting circuits disposed on a rear surface of the substrate. Here, the substrate may be any one of a glass substrate, a flexible substrate or a plastic substrate, and may be referred to as a backplane.

The substrate of the display module according to the embodiments may include a rear substrate electrically connected to the rear surface of the substrate through a flexible printed circuit (FPC). Here, the rear substrate may be formed in a form of a thin film form or a thin glass having a thickness of several tens of micrometers (for example, 50 µm or less). In case that the rear substrate is formed in the form of a thin film, the rear substrate may be formed of a plastic material, for example, any one of polyimide (PI), polyethylene terephthalate (PET), polythersulfone (PES), polyethylene naphtalate (PEN) or polycabonate (PC).

In the substrate according to an embodiment, side wiring may be formed at an edge portion of the substrate, and a first connection pad and a second connection pad may be electrically connected to each other, the first connection pad being disposed at the edge portion of a front surface of the substrate and the second connection pad being disposed on the rear surface of the substrate. To this end, the side wiring may be formed along the front surface, side cross section and rear surface of the substrate, and have one end electrically connected to the first connection pad and the other end electrically connected to the second connection pad. Here, a portion of the side wiring may be formed on the side cross section of the substrate, and thus protrude more than the side cross section of a TFT substrate by a thickness of the side wiring. In this case, the rear substrate may be electrically connected to the second connection pad through the FPC. A driver integrated circuit (IC) mounted on the rear surface of the TFT substrate may be directly connected to the second connection pad or indirectly connected to the second connection pad through a separate wiring.

In addition, the display module may be used in a wearable device, a portable device, a handheld device and an electronic or electronic product requiring various displays, in a single unit. The display module may also be used in small display devices such as a monitor for a personal computer, a television (TV) and the like, and large display devices such as a digital signage, an electronic display and the like, through a plurality of assembly arrangements.

The LED may be a semiconductor chip formed of an inorganic light emitting material and capable of emitting light by itself in case of being powered.

In addition, the LED may be a micro LED which has fast response speed, requires low power and has high luminance, and is thus spotlighted as a light emitting element of a next generation display. Such a micro LED is more efficient at converting electricity into a photon than a conventional liquid crystal display (LCD) or an organic light emitting diode (OLED). That is, the micro LED has higher "brightness per watt" compared to the conventional LCD or OLED display. Accordingly, the micro LED may achieve the same brightness with about half the energy of the conventional LED (a size of the width and length exceeding 100 µm X 100 µm) or the OLED display. In addition, the micro LED may implement high resolution, excellent color, contrast and brightness and thus accurately express a wide range of colors, and may implement a clear screen even in outside bright sunlight. In addition, the micro LED may be strong against a burn-in phenomenon and generate little heat, thereby ensuring its long life without deformation.

Hereinafter, the description focuses on embodiments of a display module and a repairing method of the same according to the disclosure in detail with reference to the accompanying drawings.

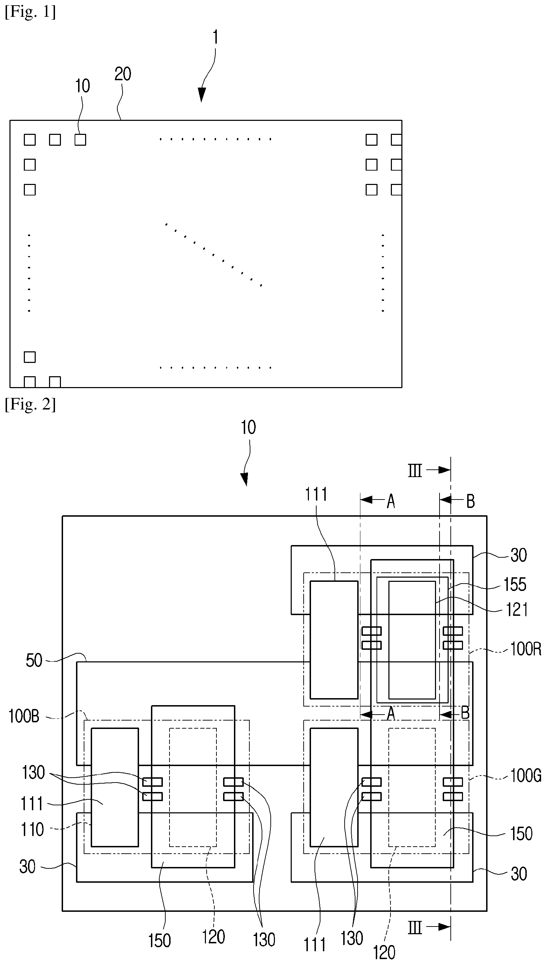

FIG. 1 is a plan view schematically illustrating a display module according to an embodiment.

Referring to FIG. 1, a display module 1 may include a substrate 20 on which a TFT is formed, and a plurality of pixels 10 formed on the substrate 20 and electrically connected to the TFT.

The display module 1 may be operated as a display including the plurality of pixels 10. A plurality of display modules 1 may be connected to each other, thereby forming one large display device. Here, the plurality of display modules 1 may be operated as one display.

The substrate 20 may implement a display screen by operating the plurality of pixels 10 arranged on the substrate 20. The substrate 20 may be configured to independently drive each of a plurality of sub-pixels 100R, 100G and 100B (see FIG. 2) forming each of the pixels 10 to be described below.

The plurality of pixels 10 may be arranged in a matrix on the substrate 20 in a first direction and a second direction perpendicular to the first direction.

However, the arrangement of the pixels according to the embodiment may not be necessarily limited thereto, and the pixels P in the first direction and/or the second direction may be arranged in various patterns such as a zigzag pattern.

Each of the pixels 10 may include a plurality of sub-pixels 100R, 100G and 100B (see FIG. 2) which emit light of colors different from one another, and all the plurality of sub-pixels 100R, 100G and 100B may have the same structure.

Hereinafter, the description focuses on a detailed configuration and structure of the pixel 10.

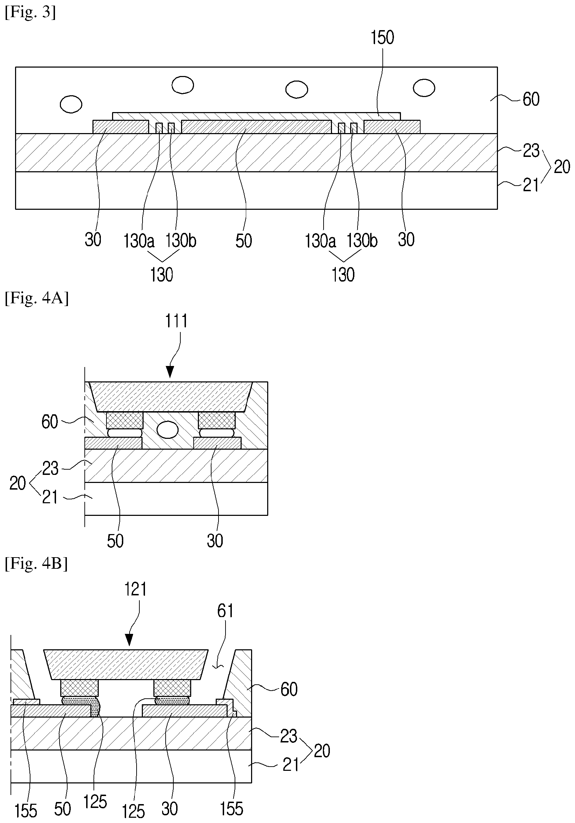

FIG. 2 is a plan view schematically illustrating a pixel according to an embodiment, and FIG. 3 is a cross-sectional view taken along line 'III-III' of FIG. 2.

Referring to FIG. 2, the pixel 10 may include the plurality of sub-pixels 100R, 100G and 100B which emit light of colors different from one another, and a first electrode 30 and a second electrode 50 both electrically connected to LEDs 111 and 121 which are mounted on each of the plurality of sub-pixels 100R, 100G and 100B.

Each of the plurality of sub-pixels 100 may include an R sub-pixel 100R, a G sub-pixel 100G, and a B sub-pixel 100B. The R sub-pixel 100R is configured to emit red light, the G sub-pixel 100G is configured to emit green light and the B sub-pixel 100B is configured to emit blue light.

The three sub-pixels 100 forming the one pixel 10 may be arranged in a triangular shape. FIG. 2 illustrates that the plurality of sub-pixels 100R, 100G and 100B are arranged in a triangle shape, but may not be limited thereto. The plurality of sub-pixels 100R, 100G and 100B may be arranged in parallel in one direction, and be arranged in various forms as necessary.

Each of the plurality of sub-pixels 100R, 100G and 100B may include the first LED 111 mounted on the substrate 20.

Meanwhile, in case that a defect is detected in the sub-pixel 100R, the new LED 121 may be mounted on the defective sub-pixel 100R through a repairing process described below. Therefore, in the display module 1 in which the defective sub-pixel is repaired, at least one sub-pixel 100R of the plurality of sub-pixels 100R, 100G or 100B may include the first LED 111 and the second LED 121 disposed adjacent to the first LED 111. The first LED and the second LED may be an LED of the same standard, and for example, may be a micro LED of the same standard.

For convenience of explanation, FIG. 2 illustrates that: the R sub-pixel 100R includes the first LED 111 and the second LED 121 to describe a state in which the defect is detected and thus the repairing process is performed; and the G sub-pixel 100G and the B sub-pixel 100B each includes only the first LED 111 to describe a state in which the repairing process is not performed.

Hereinafter, the description first focuses on a common structure of the sub-pixels 100R, 100G and 100B, and then the description with respect to FIG. 4 focuses on a structure of the R sub-pixel 100R including the first and second LEDs 111 and 121.

Referring to FIGS. 2 and 3, the substrate 20 may include a base substrate 21 and the TFT 23 formed on the base substrate 21.

The substrate 20 may be formed of a material such as polyimide (PI), PET, metal foil, poly vinyl chloride (PVC), polymethyl methacrylate (PMMA) or the like, the material having a thickness of 1 mm or less.

The base substrate 21 may be formed as a base layer of the substrate 20, and a plurality of TFTs 23 may be formed as one layer on the base substrate 21. The base substrate 21 may be a glass substrate.

The plurality of TFTs 23 may each serve to control and drive at least one LED forming the sub-pixels 100R, 100G or 100B, and may thus be electrically connected to the at least one LED. The plurality of TFTs 23 may be disposed to control the plurality of LEDs forming the plurality of sub-pixels 100R, 100G and 100B.

Each of the TFTs 23 may be electrically connected to the first electrode 30 and the second electrode 50 disposed on the TFT 23. At least one LED 111 may be mounted on the first electrode 30 and the second electrode 50 to form the sub-pixels 100R, 100G or 100B.

Accordingly, the TFT 23 receiving an electrical signal driving the LED from a driver (not illustrated) may selectively flow current to the LED through the first electrode 30 and the second electrode 50, thereby controlling an operation of the LED.

Each of the sub-pixels 100R, 100G and 100B may include the first electrode 30 and the second electrode 50 which are connected to the TFT 23.

The first electrode 30 and the second electrode 50 may be disposed on the substrate 20. The first electrode 30 and the second electrode 50 may be formed by being stacked or deposited on the TFT 23.

The first electrode 30 and the second electrode 50 may be disposed in parallel to each other. FIG. 2 illustrates that the first electrode 30 and the second electrode 50 are arranged in parallel to each other, but may not be limited thereto. The first electrode 30 and the second electrode 50 may be disposed in various forms. For example, although not illustrated, one electrode may be disposed in a U-shape surrounding the other electrode.

The first electrode 30 and the second electrode 50 may be disposed to have a predetermined interval.

The interval between the first electrode 30 and the second electrode 50 may be formed to correspond to a length of each of the LEDs 111 and 121 mounted thereon. The interval between the first electrode 30 and the second electrode 50 may be shorter than longer sides of the LEDs 111 and 121.

Here, the first electrode 30 may be disposed individually for each of the plurality of sub-pixels 100R, 100G and 100B. The second electrode 50 may be disposed to connect one ends of the plurality of LEDs disposed in the plurality of sub-pixels 100R, 100G and 100B in common.

The first electrode 30 may be an individual electrode, and the second electrode 50 may be a common electrode.

The first electrode 30 and the second electrode 50 may be disposed in each of the sub-pixels 100R, 100G and 100B. In case that power is supplied to the first electrode 30 or second electrode 50, the first LED 111 mounted on the first electrode 30 and the second electrode 50 may emit light.

The first LED 111 may be electrically connected to the first electrode 30 and the second electrode 50 through a bonding layer 60.

The bonding layer 60 may be formed on the substrate 20. The bonding layer 60 may be formed of an (generally thermosetting) adhesive resin containing a fine conductive particle. For example, the bonding layer 60 may be formed of a conductive adhesive such as an anisotropic conductive film (AFC).

Each of the sub-pixels 100R, 100G and 100B may include: a first region 110 on which the first LED 111 is mounted; a second region 120 on which a new second LED 121 is mounted on case that the first LED 111 is mounted on the first region 110 is defective; and a slit 130 disposed between the first region 110 and the second region 120.

The first region 110 is a region on which the first LED 111 forming the sub-pixels 100R, 100G and 100B may be mounted. The first electrode 30 and the second electrode 50 may be electrically connected to the first LED 111 and disposed in the first region 110. The first electrode 30 and the second electrode 50 may each be formed of a conductive metal.

The first region 110 may be formed perpendicular to the first electrode 30 and the second electrode 50, and thus partially include the first electrode 30 and the second electrode 50 disposed in parallel to each other.

The first LED 111 may be mounted on the first region 110 in such a manner that two terminals of the first LED 111 are connected to the first electrode 30 and the second electrode 50, respectively.

The second region 120 may be formed adjacent to the first region 110. The second region 120 is a region on which the new second LED 121 may be mounted on case that the defect occurs in the first LED 111 mounted on the first region 110.

The first electrode 30 and the second electrode 50 may be electrically connected to the second LED 121 and mounted on the second region 120. The second region 120 may be formed perpendicular to the first electrode 30 and the second electrode 50, and thus partially include the first electrode 30 and the second electrode 50 disposed in parallel to each other.

The first electrode 30 and the second electrode 50 may be formed long in one direction to be disposed over the first region 110 and the second region 120. Accordingly, each of the plurality of LEDs 111 and 121 may be connected to both the first electrode 30 and the second electrode 50.

A sacrificial layer 150 covering the second region 120 may be formed on the substrate 20.

The bonding layer 60 formed of the thermosetting resin may be cured in a process of mounting the first LED 111 in which high temperature and high pressure are applied onto the bonding layer 60. In this process, the bonding layer 60 disposed on the second region 120 may also be cured, and thus it is impossible to bond the new second LED 121 onto the first electrode 30 and the second electrode 50 using the bonding layer 60.

Therefore, in case that the defect occurs in the first LED 111 mounted on the first region 110, the bonding layer 60 formed on the second region 120 needs to be removed to mount the second LED 121 on the second region 120.

The sacrificial layer 150 may allow the bonding layer 60 formed on the second region 120 to be easily removed, and may protect the substrate 20 from damage which may be applied to the substrate 20 in a process of removing the bonding layer 60.

The sacrificial layer 150 may be formed wider than the second region 120 on which the second LED 121 is mounted. In detail, the sacrificial layer 150 may be formed on the first electrode 30 and the second electrode 50, to which the second LED 121 is connected, and the slit 130.

The sacrificial layer 150 may be formed to partially cover the first electrode 30 and the second electrode 50. In addition, the sacrificial layer 150 may be formed to cover a portion or an entire of the slit 130.

The sacrificial layer 150 may be formed of an inorganic material, an organic material or a metal. The inorganic material used herein may be, for example, morphous silicon, silicon dioxide (SiO₂), silicon nitride (SiNx), gallium nitride (GaN), aluminum gallium arsenide (AlGaAs), gallium arsenide phosphide (GaAsP), aluminum gallium indium phosphide (AlGaInP), gallium phosphide (GaP), etc. The organic material used herein may be, for example, carbinol polysiloxane, hydroxy-terminated carbinol polysiloxane, isophorone diisocyanate, polyimide, poly methyl methacrylate (PMMA), benzocyclobutene (BCB), acrylate, epoxy, polyester, etc. The metal used herein may be oxide (IZO), indium tin oxide (ITO), titanium (Ti), aluminum (Al), molybdenum (Mo), copper (Cu), chromium (Cr), chromium nitride (CrN), aluminum oxide (Al2O₃), etc.

The slit 130 may protect the TFT 23 disposed beneath the slit 130 in the process of removing the bonding layer 60. The below description focuses on a method of removing the bonding layer 60 formed on the second region 120 using the sacrificial layer 150.

The slit 130 may be disposed between the first electrode 30 and the second electrode 50. The slit 130 may also be disposed on a region in which the first electrode 30 and the second electrode 50 are not disposed. In addition, the slit 130 may be disposed on an outside of the second region 120. The slit 130 may be spaced apart from the first electrode 30 and the second electrode 50 at a predetermined interval, and thus a short-circuit may not occur therebetween.

The slit 130 may be formed of the same material as the first electrode 30 and the second electrode 50.

The slit 130 may be disposed on the same plane as the first electrode 30 and the second electrode 50. The slit 130 may be formed together in the same TFT process as the first electrode 30 and the second electrode 50. For example, the slit 130 may be formed by being stacked (or deposited) on the TFT 23.

The slit 130 may be disposed to protect the TFT 23 disposed on the substrate 20 in the process of removing the bonding layer 60 formed on the second region 120 to mount the second LED 121 on the second region 120.

The bonding layer 60 may be removed using a laser beam irradiation. In this case, the TFT 23 may be damaged by the laser beam irradiated on the bonding layer 60. The slit 130 may prevent the TFT 23 from being damaged by minimizing the laser beam irradiated on the TFT 23 by reflecting the laser beam.

Meanwhile, like the slit 130, the first electrode 30 and the second electrode 50 may also prevent the TFT 23 from being damaged by minimizing the laser beam irradiated on the TFT 23 by reflecting the laser beam.

The slit 130 may be disposed on the outside of the second region 120 on which the laser beam is irradiated.

The slit 130 may be formed in a linear shape or elongated rectangular shape between the first electrode 30 and the second electrode 50. The slit 130 may properly cover a space between the first electrode 30 and the second electrode 50, i.e. a top surface of the TFT 23 exposed between the first electrode 30 and the second electrode 50. The slit 130 may then reflect and diffract the laser beam incident between the first electrode 30 and the second electrode 50. In this manner, the slit 130 may minimize intensity of the laser beam incident on the TFT 23.

Referring to FIG. 3, the slit 130 may include a plurality of slits 130a and 130b. The plurality of slits 130a and 130b may be disposed in parallel to each other. The plurality of slits 130a and 130b may reflect the laser beam incident between the first electrode 30 and the second electrode 50, or diffract the laser beam using a narrow gap formed between the plurality of slits 130a and 130b. In this manner, the plurality of slits 130a and 130b may minimize the laser beam incident on the TFT 23.

FIG. 4A is a cross-sectional view taken along line 'A-A' of FIG. 2, and FIG. 4B is a cross-sectional view taken along line 'B-B' of FIG. 2.

Hereinafter, a structure of the R sub-pixel 100R including the second LED 121 is described in detail focusing on its repairing process. FIG. 4A illustrates the first region 110 of the R sub-pixel 100R, and FIG. 4B illustrates the second region 120 of the R sub-pixel 100R.

In case that the defect is detected in the sub-pixel 100R, the new LED 121 may be mounted on the defective sub-pixel 100R through the repairing process. For example, the description focuses on the defective first LED 111 mounted on the R sub-pixel 100R. In detail, the description focuses on a repaired structure of an off-dot defective sub-pixel in which the first LED 111 fails to emit light.

Referring to FIGS. 4A and 4B, one sub-pixel 100R of the plurality of sub-pixels 100R, 100G and 100B may include the first LED 111 mounted on the substrate 20 and the second LED 121 disposed adjacent to the first LED 111.

Here, the second LED 121 may be an LED emitting the same light as the first LED 111. In the embodiment, the second LED 121 may emit red light. Accordingly, the second LED 121 may form the R sub-pixel 100R instead of the defective first LED 111.

The second LED 121 may be bonded to the first electrode 30 and the second electrode 50 disposed in the second region 120. An accommodation space 61 may be formed in the second region 120 and accommodate the second LED 121 therein.

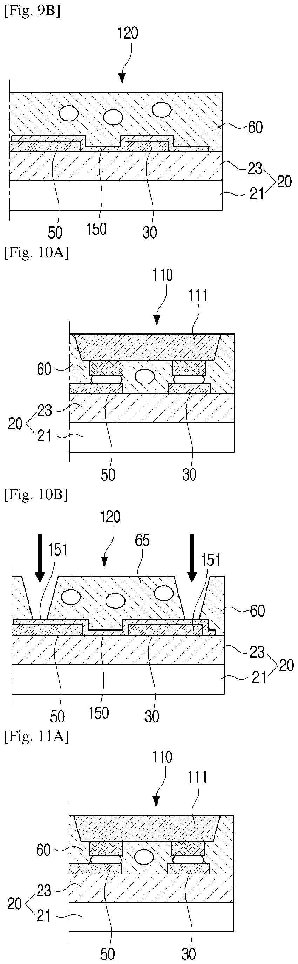

The accommodation space 61 may be formed by removing a cured bonding layer 65 (see FIG. 9B) disposed on the second region 120 to dispose the second LED 121 therein.

The second LED 121 may be mounted on the first electrode 30 and the second electrode 50 through a separate bonding member 125. The second LED 121 may be electrically connected to the first electrode 30 and the second electrode 50 through the bonding member 125.

The bonding member 125 may be disposed between the second LED 121 and the substrate 20. The bonding member 125 may be formed of a conductive material. For example, the bonding member 125 may be formed of a conductive adhesive.

In case that the first LED 111 is defective, the defective sub-pixel may be easily repaired by additionally mounting the second LED 121 therein without replacing the first LED.

Here, a remaining sacrificial layer 155 may be disposed in a band shape along an edge of the second region 120. That is, the remaining sacrificial layer 155 may be disposed to surround an outer periphery of the second LED 121. One portion of the sacrificial layer 150 formed on the second region 120 may be removed and then the second LED 121 may be mounted on the second region 120. Therefore, the other portion of the sacrificial layer 150 may remain as the remaining sacrificial layer 155 on the substrate 20 in the band shape.

This remaining sacrificial layer 155 may be disposed on the first electrode 30 and the second electrode 50 connected to the second LED 121 to have a predetermined thickness along the edge of the second region 120. In addition, the remaining sacrificial layer 155 may remain between the first electrode 30 and the second electrode 50 and at a portion of the slit 130 disposed on an outside of the second LED 121.

The slit 130 may be disposed along the edge of the second region 120 to protect the TFT 23 in the process of removing the cured bonding layer 65 (see FIG. 9B) formed on the second region 120.

FIGS. 2, 3, 4A and 4B illustrate that the R sub-pixel 100R includes the first LED 111 and the second LED 121, but may not be limited thereto. As another example, in case that the first LED 111 is defective, the defective sub-pixel among the plurality of sub-pixels 100R, 100G and 100B may include both the first LED 111 and second LED 121 through its repairing process described below.

At least one sub-pixel of the plurality of sub-pixels 100R, 100 or 100B may include at least one LED. In case that no defect is detected in the sub-pixels 100R, 100G and 100B, the sub-pixels 100R, 100G and 100B may each include only the first LED 111. However, the defective sub-pixel 100R, 100G or 100B may include the first LED 111 and the second LED 121.

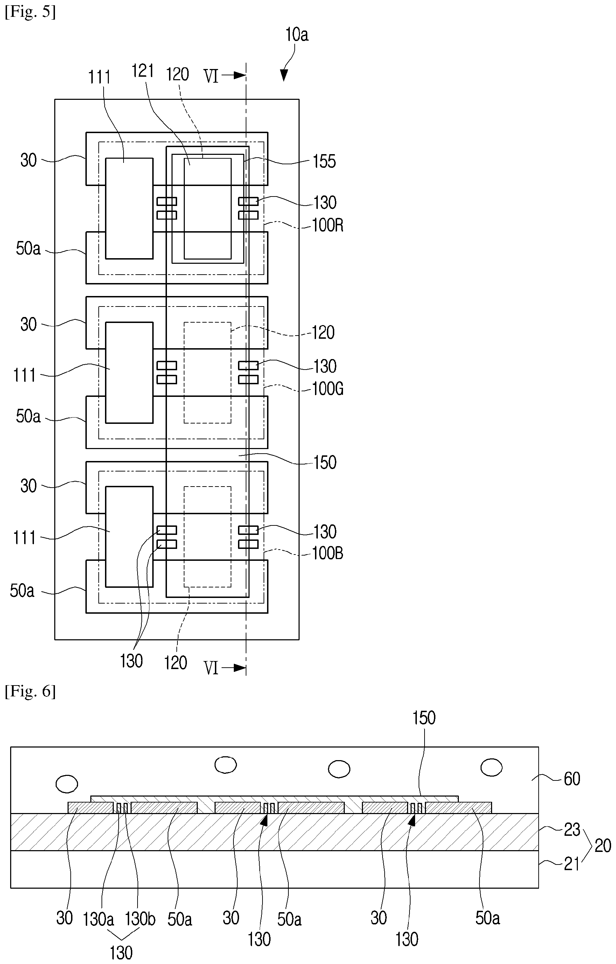

FIG. 5 is a plan view schematically illustrating a pixel according to another embodiment, and FIG. 6 is a cross-sectional view taken along line 'VI-VI' of FIG. 5.

Referring to FIGS. 5 and 6, a pixel 10a according to another embodiment has substantially the same configuration as that of the pixel 10 described with reference to FIG. 2. However, the pixel 10a is different from the pixel 10 of FIG. 2 in that a first electrode 30 and a second electrode 50a are each formed as an individual electrode. Therefore, omitted is a detailed description regarding a configuration of the pixel 10a according to another embodiment, which overlaps that of the pixel 10 described with reference to FIG. 2.

The pixel 10a may include a plurality of sub-pixels 100R, 100G and 100B which emit light of colors different from one another, and the first electrode 30 and the second electrode 50a both electrically connected to each of LEDs 111 and 121 which are mounted on each of the plurality of sub-pixels 100R, 100G and 100B.

The three sub-pixels 100R, 100G and 100B forming the single pixel 10a may be arranged in parallel to one another. FIG. 5 illustrates that the plurality of sub-pixels 100R, 100G and 100B are arranged in parallel to one another, in a perpendicular direction, but may not be limited thereto. The plurality of sub-pixels 100R, 100G and 100B may be arranged in parallel to one another in a horizontal direction or arranged in parallel to one another to have an inclination in one direction. In addition, the plurality of sub-pixels 100R, 100G and 100B may have various arrangement forms as necessary.

Each of the plurality of sub-pixels 100R, 100G and 100B may include the first LED 111 mounted on a substrate 20.

Meanwhile, in case that a defect is detected in the sub-pixel 100R, the new LED 121 may be mounted on the defective sub-pixel 100R through a repairing process described below. In this case, at least one sub-pixel 100R of the plurality of sub-pixels 100R, 100G or 100B may include the first LED 111 and the second LED 121 disposed adjacent to the first LED 111.

For convenience of explanation, FIG. 5 illustrates that: the R sub-pixel 100R includes the first LED 111 and the second LED 121 to describe a state in which the defect is detected and thus the repairing process is performed; and the G sub-pixel 100G and the B sub-pixel 100B each includes only the first LED 111 to describe a state in which the repairing process is not performed.

Each of the sub-pixels 100R, 100G and 100B may include the first electrode 30 and the second electrode 50a which are connected to a TFT 23.

The first electrode 30 and the second electrode 50a may be power electrodes individually disposed in each of the sub-pixels 100R, 100G and 100B.

Each of the sub-pixels 100R, 100G and 100B may include: the first region 110 on which the first LED 111 is mounted; the second region 120 on which the new second LED 121 is mounted in case that the first LED 111 mounted on the first region 110 is defective; and a slit 130 disposed between the first region 110 and the second region 120.

The first region 110 is a region on which the first LED 111 forming the sub-pixels 100R, 100G or 100B may be mounted, and the second region 120 is a region on which the new second LED 121 may be mounted on case that the defect occurs in the first LED 111 mounted on the first region 110.

Both the first electrode 30 and the second electrode 50a may be disposed on each of the first region 110 and the second region 120. The first electrode 30 and the second electrode 50a may be formed long in one direction to be disposed over the first region 110 and the second region 120. Accordingly, each of the two LEDs 111 and 121 may be connected to both the first electrode 30 and the second electrode 50a.

A sacrificial layer 150 covering the second region 120 may be formed on the substrate 20.

The sacrificial layer 150 may be formed to cover the first electrode 30 and the second electrode 50a, which are disposed on the second region 120, and the slit 130.

The slit 130 may be disposed between the first electrode 30 and the second electrode 50 on an outside of the second region 120. The slit 130 may be disposed at a position that does not interfere with the second LED 121 mounted on the second region 120 between the first electrode 30 and the second electrode 50a.

The slit 130 may be formed of the same material as the first electrode 30 and the second electrode 50a. The slit 130 may be disposed on the same plane as the first electrode 30 and the second electrode 50a. That is, the slit 130 may be formed on a top surface of the TFT 23 on which the first electrode 30 and the second electrode 50a are formed.

The R sub-pixel 100R may include the second LED 121 through the repairing process. In case that the defect is detected in the sub-pixel 100R, the new LED 121 may be mounted on the defective sub-pixel 100R through the repairing process. For example, it may be assumed that the first LED 111 mounted on the R sub-pixel 100R is defective. In detail, the description focuses on a repaired configuration of an off-dot defective sub-pixel in which the first LED 111 fails to emit light.

In case that the first LED 111 is defective, the defective sub-pixel may be easily repaired by additionally mounting the second LED 121 therein without replacing the first LED 111.

Here, a remaining sacrificial layer 155 may be disposed in a band shape along an edge of the second region 120. That is, the remaining sacrificial layer 155 may be disposed to surround an outer periphery of the second LED 121.

The remaining sacrificial layer 155 may remain on the first electrode 30 and the second electrode 50a connected to the second LED 121 to have a predetermined thickness along the edge of the second region 120. In addition, in case of the repaired R sub-pixel 100R, the remaining sacrificial layer 155 may remain between the first electrode 30 and the second electrode 50a included in the second region 120 and at a portion of the slit 130 disposed on an outside of the second LED 121.

At least one defective sub-pixel 100R of the plurality of sub-pixels 100R, 100G or 100B, may include the two LEDs, i.e. the first and second LEDs 111 and 121. The nondefective sub-pixels 100G and 100B may each include only the first LED 111.

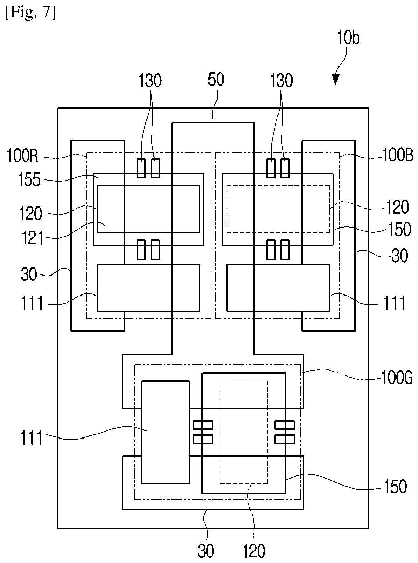

FIG. 7 is a plan view schematically illustrating a pixel according to still another embodiment.

Referring to FIG. 7, the pixel 10b according to still another embodiment has substantially the same configuration as that of the pixel 10 described with reference to FIG. 2. However, the pixel 10b according to still another embodiment has a different arrangement configuration of the first electrode 30 and the second electrode 50 from that of the pixel 10 described above. Therefore, omitted is a detailed description regarding a configuration of the pixel 10b according to still another embodiment, which overlaps that of the pixel 10 described with reference to FIG. 2.

The pixel 10b may include a plurality of sub-pixels 100R, 100G and 100B which emit light of colors different from one another, and a first electrode 30 and a second electrode 50 electrically connected to LEDs 111 and 121 mounted on the plurality of sub-pixels 100R, 100G and 100B, respectively.

The three sub-pixels 100R, 100G and 100B forming a single pixel 10b may be arranged in a triangular shape. FIG. 2 illustrates that the plurality of sub-pixels 100R, 100G and 100B are arranged in a substantially right triangular shape. However, FIG. 7 illustrates that the plurality of sub-pixels 100R, 100G and 100B are arranged in a substantially equilateral triangular shape.

The first electrode 30 may be disposed individually for each of the sub-pixels 100R, 100G and 100B. The second electrode 50 may be disposed to connect one ends of the plurality of LEDs disposed in the plurality of sub-pixels 100R, 100G and 100B in common.

In detail, the second electrode 50 may be formed in an inverted T shape between the plurality of sub-pixels 100R, 100G and 100B, and the first electrodes 30 may be disposed in parallel to respective side portions of the second electrode 50.

The first electrode 30 may be an individual electrode, and the second electrode 50 may be a common electrode.

The first electrode 30 and the second electrode 50 may be disposed on each of the sub-pixels 100R, 100G and 100B. In case that power is supplied to the first electrode 30 or the second electrode 50, the mounted first LED 111 may emit light.

The first LED 111 may be electrically connected to the first electrode 30 and the second electrode 50 through a bonding layer 60.

Meanwhile, in case that a defect is detected in the sub-pixel 100R, the new LED 121 may be mounted on the defective sub-pixel 100R through a repairing process described below. At least one sub-pixel 100R of the plurality of sub-pixels 100R, 100G or 100B may include the first LED 111 and the second LED 121 disposed adjacent to the first LED 111.

For convenience of explanation, FIG. 7 illustrates that: the R sub-pixel 100R includes the first LED 111 and the second LED 121 to describe a state in which the defect is detected and thus the repairing process is performed; and the G sub-pixel 100G and the B sub-pixel 100B each includes only the first LED 111 to describe a state in which the repairing process is not performed.

Each of the sub-pixels 100R, 100G and 100B may include the first electrode 30 and the second electrode 50 which are connected to a TFT 23.

The first electrode 30 may be a power electrode individually disposed in each of the sub-pixels 100R, 100G and 100B, and the second electrode 50 may be a common electrode disposed to supply power to each of the sub-pixels 100R, 100G and 100B in common.

Each of the sub-pixels 100R, 100G and 100B may include: a first region 110 on which the first LED 111 is mounted; a second region 120 on which the new second LED 121 is mounted on case that the first LED 111 mounted on the first region 110 is defective; and a slit 130 disposed between the first region 110 and the second region 120.

The first region 110 is a region on which the first LED 111 forming the sub-pixels 100R, 100G and 100B may be mounted, and the second region 120 is a region on which the new second LED 121 may be mounted on case that the defect occurs in the first LED 111 mounted on the first region 110.

Both the first electrode 30 and the second electrode 50 may be disposed on each of the first region 110 and the second region 120. The first electrode 30 and the second electrode 50 may be formed long in one direction to be disposed over the first region 110 and the second region 120. Accordingly, each of the plurality of LEDs 111 and 121 may be connected to both the first electrode 30 and the second electrode 50.

The plurality of first electrodes 30 may extend in parallel to respective side portions of the second electrode 50.

A sacrificial layer 150 covering the second region 120 may be formed on the substrate 20. The sacrificial layer 150 may be formed to cover the first electrode 30 and the second electrode 50, which are disposed on the second region 120, and the slit 130.

The slit 130 may be disposed between the first electrode 30 and the second electrode 50 on an outside of the second region 120. The slit 130 may be disposed at a position that does not interfere with the second LED 121 disposed on the second region 120 between the first electrode 30 and the second electrode 50.

The slit 130 may be formed of the same material as the first electrode 30 and the second electrode 50. The slit 130 may be disposed on the same plane as the first electrode 30 and the second electrode 50. That is, the slit 130 may be formed on a top surface of the TFT 23 on which the first electrode 30 and the second electrode 50 are formed.

The R sub-pixel 100R may include the second LED 121 through the repairing process. For example, it may be assumed that the first LED 111 mounted on the R sub-pixel 100R is defective. In detail, the description focuses on a repaired configuration of an off-dot defective sub-pixel in which the first LED 111 fails to emit light.

In case that the first LED 111 is defective, the defective sub-pixel may be easily repaired by additionally mounting the second LED 121 therein without replacing the first LED 111.

Here, a remaining sacrificial layer 155 may be disposed in a band shape along an edge of the second region 120. That is, the remaining sacrificial layer 155 may be disposed to surround an outer periphery of the second LED 121.

The remaining sacrificial layer 155 may remain on the first electrode 30 and the second electrode 50 connected to the second LED 121 to have a predetermined thickness along the edge of the second region 120. In addition, in case of the repaired R sub-pixel 100R, the remaining sacrificial layer 155 may remain between the first electrode 30 and the second electrode 50 included in the second region 120 and at a portion of the slit 130 disposed on an outside of the second LED 121.

At least one defective sub-pixel 100R of the plurality of sub-pixels 100R, 100G or 100B, may include the two LEDs, i.e. the first and second LEDs 111 and 121. The nondefective sub-pixels 100G and 100B may each include only the first LED 111.

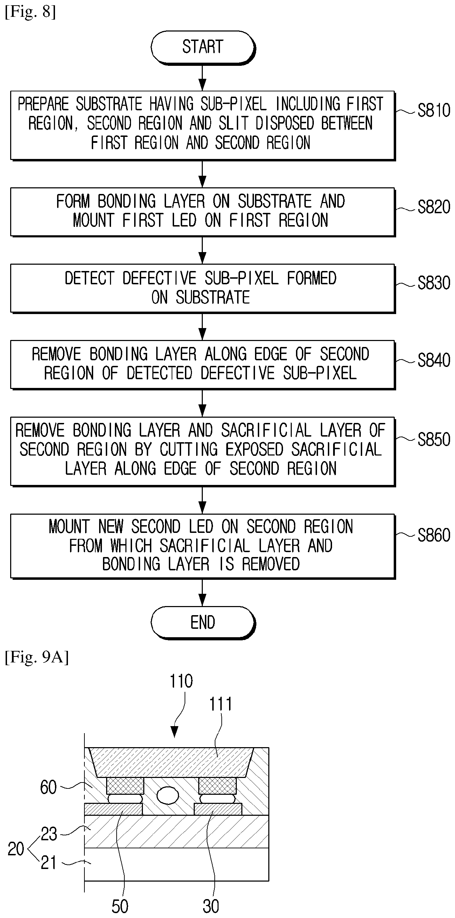

Hereinafter, the description focuses on a repairing method of a display module having the above configuration according to an embodiment with reference to FIG. 8.

FIG. 8 is a flowchart illustrating a repairing method of a display module according to an embodiment.

Referring to FIG. 8, a repairing method of a display module 1 according to an embodiment includes: preparing a substrate 20 having sub-pixels 100R, 100G and 100B each including a first region 110, a second region 120 and a slit 130 (S810); forming a bonding layer 60 on the substrate 20 and mounting a first light emitting diode (LED) 111 on the first region 110 (S820); detecting the defective sub-pixel 100R, 100G or 100B formed on the substrate 20 (S830); removing the bonding layer 60 along an edge of the second region 120 of the detected defective sub-pixel 100R, 100G or 100B (S840); removing the sacrificial layer 150 and the bonding layer 60 of the second region 120 by cutting a sacrificial layer 150 exposed along the edge of the second region 120 (S850); and mounting a new second LED 121 on the second region 120 from which the sacrificial layer 150 and the bonding layer 60 is removed.

Hereinafter, the description focuses on a detailed method of each process with reference to FIGS. 9A, 9B, 10A, 10B, 11A, 11B, 12A and 12B.

FIGS. 9A, 9B, 10A, 10B, 11A, 11B, 12A and 12B are views for describing a repairing method of a display module according to an embodiment.

For convenience of explanation, FIG. 9A is a cross-sectional view of the first region 110 of the sub-pixel taken along the line 'A-A' of FIG. 2, and FIG. 9B is a cross-sectional view of the second region 120 of the sub-pixel taken along the line 'B-B' of FIG. 2.

First, the substrate 20 may be formed to include the sub-pixels 100R, 100G and 100B each including the first region 110, the second region 120 and the slit 130 (S810).

The sub-pixels 100R, 100G and 100B formed on the substrate 20 may each include the first region 110, the second region 120 and the slit 130. The first region 110 may be a region on which the first LED 111 forming the sub-pixels 100R, 100G or 100B may be mounted. The second region 120 may be formed adjacent to the first region 110 and is a region on which the new second LED 121 may be mounted on case that the defect occurs in the first LED 111 mounted on the first region 110.

The slit 130 may be disposed between the first electrode 30 and the second electrode 50 on an outside of the second region 120. The slit 130 may protect a TFT 23 disposed beneath the slit 130 in the process of removing the bonding layer 60.

The slit 130 may be disposed on a portion of a top surface of the TFT 23 on which the first electrode 30 and the second electrode 50 are not disposed, and thus protect the portion of the TFT 23 which is not protected by the first electrode 30 and the second electrode 50.

The bonding layer 60 may be formed on the substrate 20, and the first LED 111 may be mounted on the first region 110 (S820).

The bonding layer 60 may be formed on the substrate 20. The bonding layer 60 may be formed on the first electrode 30 and the second electrode 50 to electrically connect the first LED 111 to the first electrode 30 and the second electrode 50.

The first LED 111 forming the sub-pixels 100R, 100G and 100B may be mounted on the first region 110 using the bonding layer 60. The first LED 111 may be mounted on the substrate 20 under high temperature and high pressure using the bonding layer 60, thereby curing the bonding layer 60 formed of a thermosetting resin.

After the sub-pixels 100R, 100G and 100B are formed as described above, defects of the sub-pixels formed on the substrate 20 may be detected (S830).

The defective first LED 111 does not emit light. Therefore, in case that power is applied to the display module 1, there may occur an off-dot phenomenon in which the corresponding sub-pixel fails to emit light.

Hereinafter, the description focuses on the process of mounting the new second LED 121 on the second region 120 in case that the first LED 111 mounted on the first region 110 is defective.

Referring to FIGS. 10A and 10B, the bonding layer 60 may be removed along the edge of the second region 120 of the detected defective sub-pixel (S840). The bonding layer 60 may be removed using a laser beam irradiation.

The bonding layer 60 may be cured to form a cured bonding layer 65 in the process of mounting the first LED 111. Therefore, it needs to remove the cured bonding layer 65 formed on the second region 120.

A portion 151 of the sacrificial layer 150 formed on the second region 120 may be exposed to remove the cured bonding layer 65. To expose the portion 151 of the sacrificial layer 150, it needs to remove the cured bonding layer 65 disposed on the second region 120 along the edge of the second region 120.

The bonding layer 60 may be removed using the laser beam irradiation. The bonding layer 60 may be removed by irradiating the laser beam on the bonding layer 60 along the edge of the second region 120. The bonding layer 60 may be removed to an extent that the portion 151 of the sacrificial layer 150 is exposed. Then, a deep groove may be formed along the edge of the second region 120 in the bonding layer 60 corresponding to the second region 120, and the portion 151of the sacrificial layer 150 may be exposed at a bottom of the groove.

In the process of partially removing the bonding layer 60, the TFT 23 formed on the substrate 20 may be damaged by the laser beam irradiated to the bonding layer 60. However, the display module 1 according to the embodiment may include the sacrificial layer 150 disposed in the second region 120, thereby reducing damage to the TFT 23 by the laser beam irradiation in case that the bonding layer 60 is removed.

In addition, the display module 1 according to the disclosure may include the slit 130 disposed along the edge of the second region 120 to protect the TFT 23 in case that the bonding layer 60 is removed by the laser beam irradiation.

The slit 130 may be formed of a metal material and reflect or diffract the irradiated laser beam to minimize the intensity of the laser beam incident on the TFT 23. Like the slit 130, the first electrode 30 and the second electrode 50 may reflect the irradiated laser beam to protect the TFT 23 from the laser beam irradiation.

Accordingly, the slit 130 may be disposed, on the outside of the second region 120, on the portion of the top surface of the TFT 23 on which the first electrode 30 and the second electrode 50 are not disposed.

In addition, the slit 130 formed of a metal material may be spaced apart from the first electrode 30 and the second electrode 50 at a predetermined interval, and thus a short-circuit may not occur therebetween.

Meanwhile, it is described that the slit 130 is formed of a metal material, but may not be limited thereto. The slits 130 may be formed of any material capable of reducing the intensity of the laser beam irradiation or blocking the laser beam irradiation.

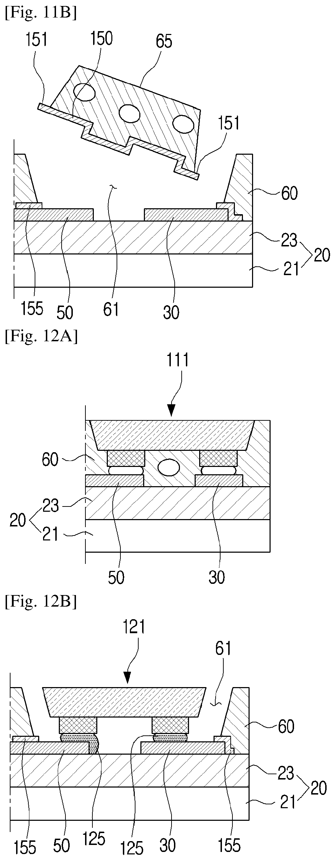

Referring to FIGS. 11A and 11B, the sacrificial layer 150 corresponding to the second region 120 and the cured bonding layer 65 formed on the sacrificial layer 150 may be removed by removing the portion 151 of the sacrificial layer 150 exposed along the edge of the second region 120 (S850).

As the portion 151 of the sacrificial layer 150, which is exposed to the outside, is removed, the sacrificial layer 150 may be separated from the substrate 20. As the sacrificial layer 150 is separated from the substrate 20, the cured bonding layer 65 formed on the sacrificial layer 150 may also be removed.

The portion 151 of the sacrificial layer 150 may be removed by a wet-etching method using an etchant. In detail, the portion 151 of the sacrificial layer 150, which is exposed to the outside, may be removed by the wet-etching method, thereby removing the sacrificial layer 150 corresponding to the second region 120.

Meanwhile, the sacrificial layer 150 may be removed using the laser beam. As the exposed portion 151 of the sacrificial layer 150 is cut out or removed using the laser beam, the sacrificial layer 150 corresponding to the second region 120 may be separated from the substrate 20. Then, the cured bonding layer 65 formed on the sacrificial layer 150 may also be separated from the substrate 20 together with the sacrificial layer 150.

In the above, it is described that the sacrificial layer 150 is removed using the wet-etching method or the laser beam method, but may not be limited thereto. The sacrificial layer 150 may be removed using other various methods.

As the sacrificial layer 150 is separated from the substrate 20, the cured bonding layer 65 formed on the sacrificial layer 150 may also be removed. The cured bonding layer 65 formed on the second region 120 may be removed, thereby forming an accommodation space 61 in which the second LED 121 may be mounted on the second region 120.

The sacrificial layer 150 may be formed wider than the second region 120 on the substrate 20, and thus the other portion of the sacrificial layer 150 may not be removed and remain as a remaining sacrificial layer 155 on the substrate 20. The remaining portion of the sacrificial layer 150, i.e. the remaining sacrificial layer 155 may remain in a band shape along the edge of the second region 120.

The one portion of the sacrificial layer 150 formed on the second region 120 may be removed to remove the cured boding layer 65 formed on the second region 120. Here, the other portion of the sacrificial layer 150 may remain as the remaining sacrificial layer 155 on an outer periphery of the second region 120 on the substrate 20 in the band shape.

This remaining sacrificial layer 155 may be disposed on the first electrode 30 and the second electrode 50 which are connected to the second LED 121 to have a predetermined thickness along the edge of the second region 120. In addition, the remaining sacrificial layer 155 may be disposed between the first electrode 30 and the second electrode 50 and at a portion of the slit 130 disposed on an outside of the second LED 121.

The slit 130 may be disposed along the edge of the second region 120 to protect the TFT 23 in the process of removing the cured bonding layer 65 formed on the second region 120 using the laser beam.

Referring to FIGS. 12A and 12B, the new second LED 121 may be mounted on the second region 120 from which the sacrificial layer 150 and the cured bonding layer 65 are removed (S860).

The second LED 121 may be disposed in the accommodation space 61. The second LED 121 disposed in the accommodation space 61 may be electrically connected to the first electrode 30 and the second electrode 50 through a separate bonding member 125.

The second LED 121 may be an LED emitting the same light as the first LED 111. Accordingly, the second LED 121 may form the sub-pixel instead of the defective first LED 111.

As described above, in case that the first LED 111 is defective, the display module 1 according to the embodiment may easily repair the defective sub-pixel by additionally mounting the second LED 121 therein without replacing the first LED 111.

The above description assumes the case that the sub-pixel has the off-dot defect and focuses on the display module having the structure capable of repairing the off-dot defective sub-pixel and the repairing method of the same.

However, it may be assumed that an on-dot defect occurs in the display module 1. In this case, it is impossible to complete the repairing because the first LED may continue to emit light even though the second LED is mounted on the second region as described above. Therefore, in case that the on-dot defect occurs in the display module 1, it is necessary to prevent the defective first LED of the sub-pixel from emitting light.

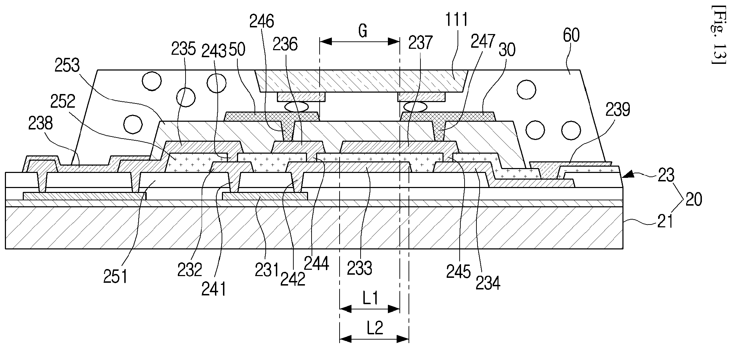

Hereinafter, the description focuses on a display module having a structure capable of repairing the on-dot defect in detail with reference to FIG. 13.

FIG. 13 is a cross-sectional view of TFT taken along the line 'A-A' of FIG. 2. For reference, FIG. 13 illustrates a configuration of the TFT 23 in detail, unlike the cross-sectional view of FIG. 4A described above.

Referring to FIG. 13, a substrate 20 may include a first LED 111 disposed on the substrate 20.

The substrate 20 may include a base substrate 21 and a plurality of TFTs 23 formed on a top surface of the base substrate 21. The base substrate 21 may be a glass substrate. The plurality of TFTs 23 may be formed in a film shape on the base substrate 21. The plurality of TFTs 23 may be formed to control a plurality of LEDs.

A plurality of pixels may be arranged on the plurality of TFTs 23. Each of the plurality of pixels may include a plurality of sub-pixels. For example, as described above, one pixel 10 may include three sub-pixels 100R, 100G and 100B. One sub-pixel may include at least one LED 111.

In addition, one sub-pixel 100R, 100G or 100B may include a first region 110 on which the first LED 111 is mounted and a second region 120 on which the second LED 121 is mounted. The TFT 23 capable of controlling the first LED 111 and the second LED 121 may be mounted on the first region 110 and the second region 120.

Hereinafter, a structure of the TFT 23 formed below the first LED 111 is described in detail with reference to FIG. 13.

Referring to FIG. 13, a display module 1 may include: a substrate 20 on which a plurality of thin film transistors (TFTs) 23 are formed; and a plurality of pixels 10 each including a plurality of sub-pixels 100R, 100G and 100B arranged on the plurality of TFTs 23. The plurality of TFTs 23 may each include: a first metal pad 231 disposed on the substrate 20; a first insulating layer 251 covering the first metal pad 231; a second metal pad 232 disposed on the first insulating layer 251 above the first metal pad 231, and connected to the first metal pad 231; a third metal pad 233 disposed on the first insulating layer 251 above the first metal pad 231, spaced apart from the second metal pad 232 and connected to the first metal pad 231; a fourth metal pad 234 disposed on the first insulating layer 251 and spaced apart from the third metal pad 233; a second insulating layer 252 covering the second metal pad 232, the third metal pad 233 and the fourth metal pad 234; a fifth metal pad 235 disposed on the second insulating layer 252 above the second metal pad 232, and connected to the second metal pad 232; a sixth metal pad 236 disposed on the second insulating layer 252 above the third metal pad 233, spaced apart from the fifth metal pad 235 and connected to the third metal pad 233; a seventh metal pad 237 disposed on the second insulating layer 252 above the fourth metal pad 234, spaced apart from the sixth metal pad 236 and connected to the fourth metal pad 234; a third insulating layer 253 covering the fifth metal pad 235, the sixth metal pad 236 and the seventh metal pad 237; a first electrode 30 disposed on the third insulating layer 253 above the seventh metal pad 237 and connected to the seventh metal pad 237; and a second electrode 50 disposed on the third insulating layer 253 above the sixth metal pad 236, connected to the sixth metal pad 236 and spaced apart from the first electrode 30 by a predetermined distance. The plurality of sub-pixels may each include at least one light emitting diode (LED) 111, and the at least one LED 111 may be connected to the first electrode 30 and the second electrode 50. The seventh metal pad 237 may be extended toward the second electrode 50 beyond the first electrode 30 to face a space between the first electrode 30 and the second electrode 50 in an upward direction and to face a portion of the third metal pad 233 in a downward direction.

In detail, the TFT 23 may include a first metal pad 231 disposed on the substrate 20, to be specific, a base substrate 21. The first metal pad 231 may form a gate electrode of the TFT 23. The base substrate 21 may be a glass substrate.

A first insulating layer 251 may be disposed on the top surface of the base substrate 21 to cover the first metal pad 231.

Second metal pad 232, third metal pad 233 and fourth metal pad 234 may be formed on a top surface of the first insulating layer 251.

The second metal pad 232 may be disposed on the first insulating layer 251 above the first metal pad 231, and connected to the first metal pad 231. That is, the second metal pad 232 may be formed above the first metal pad 231 to overlap the first metal pad 231 when viewed in a perpendicular direction, and electrically connected to the first metal pad 231 through a first via 241. The second metal pad 232 may be spaced apart from the first metal pad 231 by a predetermined distance in the perpendicular direction. Therefore, the first insulating layer 251 may be interposed between the first metal pad 231 and the second metal pad 232, and the first via 241 may connect the first metal pad 231 with the second metal pad 232 through the first insulating layer 251.

The third metal pad 233 may be disposed on the first insulating layer 251 above the first metal pad 231, spaced apart from the second metal pad 232 and connected to the first metal pad 231. That is, the third metal pad 233 may be formed above the first metal pad 231 to partially overlap the first metal pad 231 when viewed in the perpendicular direction, and electrically connected to the first metal pad 231 through a second via 242. The third metal pad 233 may be spaced apart from the first metal pad 231 by a predetermined distance in the perpendicular direction. Therefore, the first insulating layer 251 may be interposed between the first metal pad 231 and the third metal pad 233, and the second via 242 may connect the first metal pad 231 with the third metal pad 233 through the first insulating layer 251. The third metal pad 233 may be formed on the top surface of the first insulating layer 251 to be spaced apart from the second metal pad 232 by a predetermined distance. The third metal pad 233 may be connected to the first metal pad 231 serving as a gate electrode, and the third metal pad 233 may thus be referred to as a gate pad.

The fourth metal pad 234 may be disposed on the first insulating layer 251 to be spaced apart from the third metal pad 233. That is, the fourth metal pad 234 may be formed to be spaced apart from the third metal pad 233 by a predetermined distance not to overlap the first metal pad 231 when viewed in the perpendicular direction. The fourth metal pad 234 may be electrically connected to a source voltage application pad 239 capable of applying a source voltage Vss.

A second insulating layer 252 may be disposed on the top surface of the first insulating layer 251 to cover the second metal pad 232, third metal pad 233 and fourth metal pad 234.

Fifth metal pad 235, sixth metal pad 236 and seventh metal pad 237 may be formed on a top surface of the second insulating layer 252.

The fifth metal pad 235 may be disposed on the second insulating layer 252 above the second metal pad 232, and connected to the second metal pad 232. That is, the fifth metal pad 235 may be formed above the second metal pad 232 to overlap the second metal pad 232 when viewed in the perpendicular direction, and electrically connected to the second metal pad 232 through a third via 243. The fifth metal pad 235 may be spaced apart from the second metal pad 232 by a predetermined distance in the perpendicular direction. Therefore, the second insulating layer 252 may be interposed between the second metal pad 232 and the fifth metal pad 235, and the third via 243 may connect the second metal pad 232 with the fifth metal pad 235 through the second insulating layer 252. The fifth metal pad 235 may be electrically connected to a drain voltage application pad 238 capable of applying a drain voltage Vdd. The drain voltage application pad 238 may be connected to a test pad formed to apply a test voltage.

The sixth metal pad 236 may be disposed on the second insulating layer 252 above the third metal pad 233, spaced apart from the fifth metal pad 235 and connected to the third metal pad 233. That is, the sixth metal pad 236 may be formed above the third metal pad 233 to overlap the third metal pad 233 when viewed in the perpendicular direction, and electrically connected to the third metal pad 233 through a fourth via 244. The sixth metal pad 236 may be spaced apart from the third metal pad 233 by a predetermined distance in the perpendicular direction. Therefore, the second insulating layer 252 may be interposed between the third metal pad 233 and the sixth metal pad 236, and the fourth via 244 may connect the third metal pad 233 with the sixth metal pad 236 through the second insulating layer 252.

The seventh metal pad 237 may be disposed on the second insulating layer 252 above the fourth metal pad 234, spaced apart from the sixth metal pad 236 and connected to the fourth metal pad 234. That is, the seventh metal pad 237 may be formed on the top surface of the second insulating layer 252 above the fourth metal pad 234 to overlap the fourth metal pad 234 when viewed in the perpendicular direction, and electrically connected to the fourth metal pad 234 through a fifth via 245. The seventh metal pad 237 may be spaced apart from the fourth metal pad 234 by a predetermined distance in the perpendicular direction. Therefore, the second insulating layer 252 may be interposed between the fourth metal pad 234 and the seventh metal pad 237, and the fifth via 245 may connect the fourth metal pad 234 with the seventh metal pad 237 through the second insulating layer 252.

In addition, the seventh metal pad 237 may be extended above the third metal pad 233. That is, the seventh metal pad 237 may be extended toward the sixth metal pad 236 to overlap the third metal pad 233 disposed therebelow by a predetermined length L2. Therefore, the seventh metal pad 237 may be extended toward the second electrode 50 beyond the first electrode 30 to face a space between the first electrode 30 and the second electrode 50 in an upward direction and to downwardly face a portion of the third metal pad 233in a downward direction. That is, the seventh metal pad 237 may be formed to be extended beyond the first electrode 30 toward the sixth metal pad 236 by a predetermined length L1, and the seventh metal pad 237 may be formed to overlap the third metal pad 233 by the predetermined length L2. The seventh metal pad 237 may be electrically connected to the source voltage application pad 239 through the fourth metal pad 234 and thus referred to as a source pad.

As such, in case that the seventh metal pad 237 may be formed to overlap the third metal pad 233 by the predetermined length L2, the seventh metal pad 237 and the third metal pad 233 may be connected to each other by laser welding if necessary.

A third insulating layer 253 may be disposed on the top surface of the second insulating layer 252 to cover the fifth metal pad 235, the sixth metal pad 236 and the seventh metal pad 237. The TFT may be formed including the first to seventh metal pads 231, 232, 233, 234, 235, 236 and 237, and the first and second insulating layers 251 and 252, which are disposed below the third insulating layer 253.

The first electrode 30 and the second electrode 50 may be formed on a top surface of the third insulating layer 253.

The first electrode 30 may be disposed on the third insulating layer 253 above the seventh metal pad 237 and connected to the seventh metal pad 237. The first electrode 30 may be disposed on the top surface of the third insulating layer 253 to partially overlap the seventh metal pad 237 and connected to the seventh metal pad 237 through a seventh via 247. The first electrode 30 may be spaced apart from the seventh metal pad 237 by a predetermined distance in the perpendicular direction. Therefore, the third insulating layer 253 may be interposed between the seventh metal pad 237 and the first electrode 30, and the seventh via 247 may connect the first electrode 30 with the seventh metal pad 237 through the third insulating layer 253.

The second electrode 50 may be disposed on the third insulating layer 253 above the sixth metal pad 236, connected to the sixth metal pad 236 and spaced apart from the first electrode 30 by a predetermined distance G. That is, the second electrode 50 may be spaced apart from the first electrode 30 by a predetermined distance in a horizontal direction; disposed on the top surface of the third insulating layer 253 to partially overlap the sixth metal pad 236; and electrically connected to the sixth metal pad 236 through a sixth via 246. The second electrode 50 may be spaced apart from the sixth metal pad 236 by a predetermined distance in the perpendicular direction. Therefore, the third insulating layer 253 may be interposed between the sixth metal pad 236 and the second electrode 50, and the sixth via 246 may connect the second electrode 50 with the sixth metal pad 236 through the third insulating layer 253.

The first electrode 30 and the second electrode 50 may be electrically connected to the first LED 111. For example, the first electrode 30 and the second electrode 50 may be electrically connected to the first LED 111 through a fine conductive particle of an anisotropic conductive film forming the bonding layer 60.

Therefore, in case that the TFT 23 is operated to apply a voltage to the first LED 111, the first LED 111 may be turned on and emit light. In case that no voltage is applied to the first LED 111, the first LED 111 is turned off and does not emit light.

However, in case that a defect occurs in the first LED 111, the first LED 111 may emit light even though no voltage is applied thereto. That is, the on-dot defect occurs. As such, in case that the first LED 111 of any of the plurality of sub-pixels emits light even though no voltage is applied thereto, it is necessary to repair the first LED 111 not to be operated.

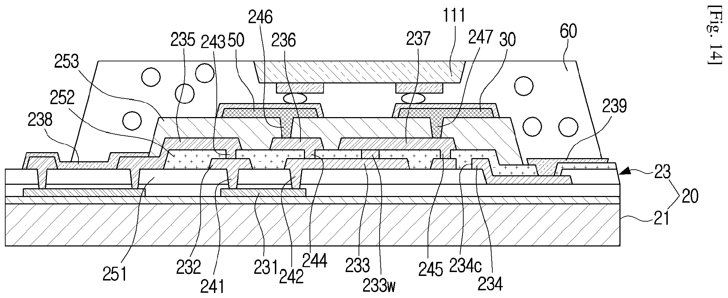

FIG. 14 is a cross-sectional view illustrating that a defective sub-pixel is repaired according to an embodiment.

As illustrated in FIG. 14, the third metal pad 233 of the TFT 23 corresponding to the first LED 111 among the plurality of TFTs may be connected with the seventh metal pad 237 by laser welding, and the fourth metal pad 234 may be disconnected from the source voltage application pad 239 using a laser beam. In this case, the first LED 111 does not emit light because the same voltage, i.e. the drain voltage is applied to the first electrode 30 and the second electrode 50 which are connected to the first LED 111.

Here, the laser beam may be irradiated on the TFT 23 from a bottom surface of the base substrate 21.

In detail, the base substrate 21 may be formed of a glass, and the third metal pad 233 and the seventh metal pad 237 may thus be welded to each other by irradiating a laser beam from below the substrate 20. Then, the third metal pad 233 and the seventh metal pad 237 may be electrically connected to each other by a welded portion 233w penetrating through the second insulating layer 252. In addition, the fourth metal pad 234 may be cut by irradiating the laser beam from below the base substrate 21. By cutting the fourth pad 234, it is possible to break the connection between the fourth metal pad 234 and the source voltage application pad 239. Therefore, it is also possible to break the electrical connection between the seventh metal pad 237 and the source voltage application pad 239.

Therefore, the source voltage applied to the source voltage application pad 239 may not be applied to the seventh metal pad 237. The drain voltage applied to the drain voltage application pad 238 may be applied to the seventh metal pad 237 through the third metal pad 233. As a result, only the drain voltage may be applied to both the first electrode 30 and the second electrode 50, which are connected to the first LED 111, and thus the first LED 111 does not emit light.

A TFT 23 controlling the second LED 121 may also be mounted on the second region 120 on which the second LED 121 of the sub-pixel is to be mounted.

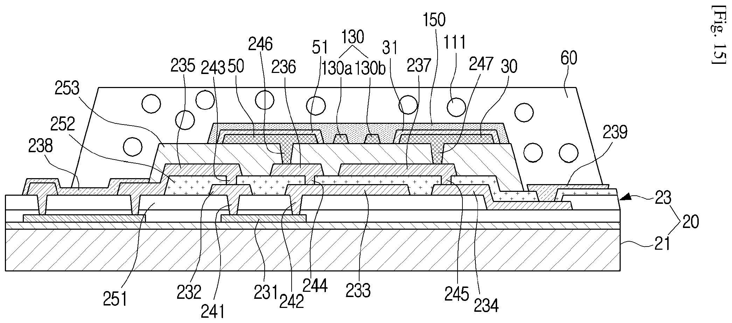

Hereinafter, referring to FIG. 15, the description focuses on a detailed configuration of a TFT 23 formed on the second region 120 on which the new second LED 121 is to be mounted on case that the defect occurs in the first LED 111.

FIG. 15 is a cross-sectional view of the TFT taken along the line 'B-B' of FIG. 2.

Referring to FIG. 15, a structure of the TFT 23 formed on the second region 120 is the same as that of the TFT 23 formed on the first region 110, i.e. below the first LED 111. Therefore, hereinafter, the description focuses on only a portion of the structure of the TFT 23 different from that of the first LED 111 illustrated in FIG. 13.

A first electrode 30 and a second electrode 50 may be disposed on a top surface of a third insulating layer 253 at a predetermined interval G. In case that the first LED 111 is defective, a new second LED may be mounted on the first electrode 30 and the second electrode 50.

A capping metal 31 may be formed on a surface of the first electrode 30 to prevent an oxidation of the first electrode 30. A capping metal 51 may be formed on a surface of the second electrode 50 to prevent an oxidation of the second electrode 50.

A slit 130 may be disposed between the first electrode 30 and the second electrode 50. The slit 130 may be disposed on the same top surface of the third insulating layer 253 as the first electrode 30 and the second electrode 50. The slit 130 may be spaced apart from the first electrode 30 and the second electrode 50 at a predetermined interval, and thus a short-circuit may not occur therebetween. The slit 130 may protect the TFT 23 disposed below the slit 130 in a process of removing a bonding layer 60.

The slit 130 may include a plurality of slits 130a and 130b. The plurality of slits 130a and 130b may be disposed in parallel to each other. The plurality of slits 130a and 130b may reflect a laser beam incident on the third insulating layer 253 disposed between the first electrode 30 and the second electrode 50, or diffract the laser beam using a narrow gap formed between the plurality of slits 130a and 130b. In this manner, the plurality of slits 130a and 130b may minimize the laser beam irradiated on the TFT 23.

The slit 130 may be formed of the same material as the first electrode 30 and the second electrode 50.

The slit 130 may be disposed on the same top surface of the third insulating layer 253 as the first electrode 30 and the second electrode 50. The slit 130 may be formed together in the same TFT process as the first electrode 30 and the second electrode 50. For example, the slit 130 may be formed by being stacked (or deposited) on the top surface of the third insulating layer 253 of the TFT 23.

The slit 130 may be formed to face a seventh metal pad 237 of the TFT 23 disposed below a sacrificial layer 150. That is, below the slit 130, there may be the seventh metal pad 237 covered by the third insulating layer 253 and extended beyond the first electrode 30 toward the sixth metal pad 236 by a predetermined length L1. Therefore, in case of cutting the sacrificial layer 150 using the laser beam, the laser beam passing through a space between the slits 130a and 130b and incident through the third insulating layer 253 may be reflected by the seventh metal pad 237. As above, in case of cutting the sacrificial layer 150 in situation that the seventh metal pad 237 is disposed below the slit 130, the laser beam incident on the TFT 23 may be diffracted by the slit 130 or reflected by the seventh metal pad 237, thereby minimizing damage to the TFT 23.

The sacrificial layer 150 may be formed on the top surface of the third insulating layer 253 to cover the first electrode 30, the second electrode 50 and the slit 130.

The seventh metal pad 237 disposed below the sacrificial layer 150 may be extended beyond the first electrode 30 toward the sixth metal pad 236 by the predetermined length L1. Therefore, in case of cutting the sacrificial layer 150 using the laser beam, the seventh metal pad 237 may reflect the laser beam incident through the third insulating layer 253. As a result, in case of cutting the sacrificial layer 150 using the laser beam to mount the new second LED 121 on the second region 120, it is possible to minimize the damage to TFT 23 disposed below the seventh metal pad 237 by the laser beam.

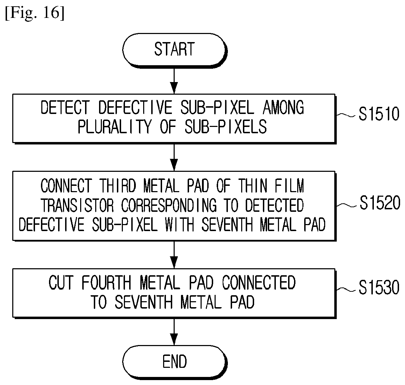

Hereinafter, referring to FIGS. 14 and 16, the description focuses on a detailed method of repairing an on-dot defect in case that the on-dot defect occurs in the display module according to an embodiment.

FIG. 16 is a flowchart illustrating a repairing method of a display module according to an embodiment.

A defective sub-pixel may be detected among a plurality of sub-pixels 100R, 100G and 100B included in each pixel 10 on a substrate 20 on which a plurality of pixels are arranged (S1510). The defective sub-pixel may include a sub-pixel not emitting light even though a voltage is applied to the substrate 20 and a sub-pixel emitting light even though no voltage is applied to the substrate 20. That is, the defective sub-pixel may include the off-dot defective sub-pixel and the on-dot defective sub-pixel.

This embodiment relates to a method of repairing the on-dot defective sub-pixel.

In case that the on-dot defective sub-pixel is detected, the third metal pad 233 of the TFT 23 corresponding to the detected defective sub pixel may be connected with the seventh metal pad 237 (S1520). The third metal pad 233 and the seventh metal pad 237 may be connected to each other using a laser beam. In detail, the third metal pad 233 may be connected with the seventh metal pad 237 by irradiating the laser beam from below the substrate 20. That is, the third metal pad 233 and the seventh metal pad 237 may be attached to each other by laser welding. Then, the third metal pad 233 and the seventh metal pad 237 may be electrically connected to each other through a welded portion 233w.

Here, the seventh metal pad 237 disposed above the third metal pad 233 may be extended on a top surface of the second insulating layer 252 to overlap the third metal pad 233 by a predetermined length L2. Therefore, by irradiating the laser beam from below the third metal pad 233, the third metal pad 233 and the seventh metal pad 237 may be electrically connected to each other through the welded portion 233w.

Next, a source voltage may be prevented from being applied to the seventh metal pad 237 by cutting the fourth metal pad 234 connected to the seventh metal pad 237 (S1530). The fourth metal pad 234 may be cut using the laser beam. In detail, the fourth metal pad 234 may be cut by irradiating the laser beam from below the substrate 20. A reference numeral 234c denotes a portion of the fourth metal pad 234 cut by the laser beam. Here, it is possible to prevent a source voltage applied to the source voltage application pad 239 from being applied to the seventh metal pad 237 by cutting between a portion of the fourth metal pad 234 connected to the sixth via 246 connected to the seventh metal pad 237 and a portion of the fourth metal pad 234 connected to a source voltage application pad 239. Therefore, it is possible to break an electrical connection between the seventh metal pad 237 and the source voltage application pad 239 by cutting the fourth metal pad 234.

As described above, in case that the third metal pad 233 is connected to the seventh metal pad 237 and the source voltage application pad 239 is not connected to the seventh metal pad 237, the source voltage may not be applied to the seventh metal pad 237, and a drain voltage may be applied to the seventh metal pad 237 through the third metal pad 233. As a result, only the drain voltage is applied to both the first electrode 30 and the second electrode 50, which are connected to the first LED 111, and thus the first LED 111 does not emit light. In this manner, it is possible to resolve the on-dot defect of the first LED 111.

The repairing method according to an embodiment is advantageous than replacing the defective LED in terms of cost. In addition, the repairing may be made by mounting the new LED on the second region of the sub-pixels already arranged without rearranging the sub-pixels during the repairing process. Therefore, it is possible to maintain the arrangement of the sub-pixels.

In addition, the repairing method according to an embodiment may not damage the on-dot defective LED itself. By welding and cutting the metal pad of the TFT formed below the defective LED, it is possible to prevent the LED from emitting light. Accordingly, it is easy to repair the on-dot defective LED. During the repairing of the LED, the laser beam may be irradiated from below the substrate. Therefore, it is possible to minimize the damage to the TFT 23 by the laser beam.

The invention is as defined by the appended claims.

## Claims

1. A display module (1) comprising:
a glass substrate (21) on which a thin film transistor, TFT, (23) is formed; and
a sub-pixel (100R, 100G, 100B) disposed on the TFT (23),
wherein the TFT (23) comprises:
a first electrode (30);
a second electrode (50) spaced apart from the first electrode (30);
a source pad (237) spaced apart from the first electrode (30) in a perpendicular direction and electrically connected to the first electrode (30); and
a gate pad (233) disposed below the source pad (237),
wherein the sub-pixel comprises a light emitting diode, LED,
wherein the LED is connected to the first electrode (30) and the second electrode (50), and **characterized in that** the source pad (237) is extended toward the second electrode (50) beyond the first electrode (30) facing a space between the first electrode (30) and the second electrode (50) in an upward direction, and facing a portion of the gate pad (233) in a downward direction.

2. The display module (1) as claimed in claim 1,
wherein the sub-pixel (100R, 100G, 100B) further comprises:
a first region (110) on which a first LED (111) is mounted, and
a second region (120) formed adjacent to the first region (110), and on which a second LED (121) is mounted, and
wherein the first electrode (30) and the second electrode (50) are disposed over the first region (110) and the first electrode (30) and the second electrode (50) are disposed over the second region (120).

3. The display module (1) as claimed in claim 2, wherein the sub-pixel (100R, 100G, 100B) further comprises a sacrificial layer (150) covering the second region (120).

4. The display module (1) as claimed in claim 3,
wherein the sub-pixel (100R, 100G, 100B) further comprises at least one slit disposed between the first electrode (30) and the second electrode (50), and
wherein the sacrificial layer (150) covers a portion of the at least one slit.

5. The display module (1) as claimed in claim 4, wherein the at least one slit comprises a first slit spaced apart from a second slit.

6. The display module (1) as claimed in claim 2, further comprising a sacrificial layer (150) disposed in a band shape along an edge of the second region (120) on which the second LED (121) is mounted.

7. The display module (1) as claimed in claim 2, wherein based on the first LED (111) of the sub-pixel emitting light when zero voltage is applied to the first LED (111), the gate pad corresponding to the first LED (111) is configured to connect with the source pad (237) by laser welding, and the source pad (237) is configured to disconnect from the metal pad using a laser beam.

8. A repairing method of a display module, comprising:
detecting a defective sub-pixel (100R, 100G, 100B) in the display module (1) of claim 1;
connecting a gate pad of a thin film transistor, TFT, (23) corresponding to the detected defective sub-pixel (100R, 100G, 100B) to a source pad (237); and
preventing a source voltage from being applied to the source pad (237) by cutting a metal pad connected to the source pad (237).

9. The repairing method of a display module (1) as claimed in claim 8, further comprising welding the gate pad to the source pad (237) using a laser beam.

10. The repairing method of a display module (1) as claimed in claim 8, wherein the metal pad is cut using a laser beam.

## Patentansprüche

1. Anzeigemodul (1), das Folgendes umfasst:
ein Glassubstrat (21), auf dem ein Dünnfilmtransistor, TFT, (23) ausgebildet ist; und
ein Subpixel (100R, 100G, 100B), das auf dem TFT (23) angeordnet ist,
wobei der TFT (23) Folgendes umfasst:
eine erste Elektrode (30);
eine zweite Elektrode (50), die von der ersten Elektrode (30) beabstandet ist;
eine Source-Kontaktfläche (237), die von der ersten Elektrode (30) in einer senkrechten Richtung beabstandet und mit der ersten Elektrode (30) elektrisch verbunden ist; und
eine Gate-Kontaktfläche (233), die unterhalb der Source-Kontaktfläche (237) angeordnet ist,
wobei das Subpixel eine lichtemittierende Diode, LED, umfasst,
wobei die LED mit der ersten Elektrode (30) und der zweiten Elektrode (50) verbunden ist, und **dadurch gekennzeichnet ist, dass**
sich die Source-Kontaktfläche (237) hin zur zweiten Elektrode (50) über die erste Elektrode (30) hinaus erstreckt,
wobei sie einem Raum zwischen der ersten Elektrode (30) und der zweiten Elektrode (50) in einer Aufwärtsrichtung zugewandt ist und einem Abschnitt der Gate-Kontaktfläche (233) in einer Abwärtsrichtung zugewandt ist.

2. Anzeigemodul (1) nach Anspruch 1,
wobei das Subpixel (100R, 100G, 100B) ferner Folgendes umfasst:
einen ersten Bereich (110), auf dem eine erste LED (111) angebracht ist, und
einen zweiten Bereich (120), der angrenzend an dem ersten Bereich (110) ausgebildet ist und auf dem eine zweite LED (121) angebracht ist, und
wobei die erste Elektrode (30) und die zweite Elektrode (50) über dem ersten Bereich (110) angeordnet sind und die erste Elektrode (30) und die zweite Elektrode (50) über dem zweiten Bereich (120) angeordnet sind.

3. Anzeigemodul (1) nach Anspruch 2, wobei das Subpixel (100R, 100G, 100B) ferner
eine Opferschicht (150) umfasst, die den zweiten Bereich (120) bedeckt.

4. Anzeigemodul (1) nach Anspruch 3,
wobei das Subpixel (100R, 100G, 100B) ferner mindestens einen Schlitz umfasst, der zwischen der ersten Elektrode (30) und der zweiten Elektrode (50) angeordnet ist, und wobei die Opferschicht (150) einen Abschnitt des mindestens einen Schlitzes bedeckt.

5. Anzeigemodul (1) nach Anspruch 4, wobei der mindestens eine Schlitz einen ersten Schlitz umfasst, der von einem zweiten Schlitz beabstandet ist.

6. Anzeigemodul (1) nach Anspruch 2, das ferner eine Opferschicht (150) umfasst, die in einer Bandform entlang einer Kante des zweiten Bereichs (120) angeordnet ist, auf dem die zweite LED (121) angebracht ist.

7. Anzeigemodul (1) nach Anspruch 2, wobei basierend auf der ersten LED (111) des Subpixels, die Licht emittiert, wenn eine Nullspannung an die erste LED (111) angelegt wird, die Gate-Kontaktfläche, die der ersten LED (111) entspricht, konfiguriert ist, um sich mit der Source-Kontaktfläche (237) durch Laserschweißen zu verbinden, und die Source-Kontaktfläche (237) konfiguriert ist, um sich von der Metallkontaktfläche unter Verwendung eines Laserstrahls zu trennen.

8. Reparaturverfahren für ein Anzeigemodul, das Folgendes umfasst:
Erkennen eines defekten Subpixels (100R, 100G, 100B) in dem Anzeigemodul (1) von Anspruch 1;
Verbinden einer Gate-Kontaktfläche eines Dünnfilmtransistors, TFT, (23), die dem erkannten defekten Subpixel (100R, 100G, 100B) entspricht, mit einer Source-Kontaktfläche (237); und
Verhindern, dass eine Source-Spannung an die Source-Kontaktfläche (237) angelegt wird, indem eine mit der Source-Kontaktfläche (237) verbundene Metallkontaktfläche geschnitten wird.

9. Reparaturverfahren für ein Anzeigemodul (1) nach Anspruch 8, das ferner das Verschweißen der Gate-Kontaktfläche mit der Source-Kontaktfläche (237) unter Verwendung eines Laserstrahls umfasst.

10. Reparaturverfahren für ein Anzeigemodul (1) nach Anspruch 8, bei dem die Metallkontaktfläche unter Verwendung eines Laserstrahls geschnitten wird.

## Revendications

1. Module d'affichage (1) comprenant :
un substrat en verre (21) sur lequel un transistor à couches minces, TFT, (23) est formé ; et
un sous-pixel (100R, 100G, 100B) disposé sur le TFT (23),
dans lequel le TFT (23) comprend :
une première électrode (30) ;
une seconde électrode (50) espacée de la première électrode (30) ;
un plot de source (237) espacé de la première électrode (30) dans une direction perpendiculaire et connecté électriquement à la première électrode (30) ; et
un plot de grille (233) disposé sous le plot de source (237),
dans lequel le sous-pixel comprend une diode électroluminescente, LED,
dans lequel la LED est connectée à la première électrode (30) et à la seconde électrode (50), et
**caractérisé en ce que**
le plot de source (237) est étendu vers la seconde électrode (50) au-delà de la première électrode (30) faisant face à un espace entre la première électrode (30) et la seconde électrode (50) dans une direction vers le haut, et faisant face à une partie du plot de grille (233) dans une direction vers le bas.

2. Module d'affichage (1) selon la revendication 1,
dans lequel le sous-pixel (100R, 100G, 100B) comprend en outre :
une première région (110) sur laquelle une première LED (111) est montée, et
une seconde région (120) formée de manière adjacente à la première région (110), et sur laquelle une seconde LED (121) est montée, et
dans lequel la première électrode (30) et la seconde électrode (50) sont disposées au-dessus de la première région (110) et la première électrode (30) et la seconde électrode (50) sont disposées au-dessus de la seconde région (120).

3. Module d'affichage (1) selon la revendication 2, dans lequel le sous-pixel (100R, 100G, 100B) comprend en outre une couche sacrificielle (150) recouvrant la seconde région (120).

4. Module d'affichage (1) selon la revendication 3,
dans lequel le sous-pixel (100R, 100G, 100B) comprend en outre au moins une fente disposée entre la première électrode (30) et la seconde électrode (50), et
dans lequel la couche sacrificielle (150) recouvre une partie de l'au moins une fente.

5. Module d'affichage (1) selon la revendication 4, dans lequel l'au moins une fente comprend une première fente espacée d'une seconde fente.

6. Module d'affichage (1) selon la revendication 2, comprenant en outre une couche sacrificielle (150) disposée en forme de bande le long d'un bord de la seconde région (120) sur laquelle la seconde LED (121) est montée.

7. Module d'affichage (1) selon la revendication 2, dans lequel, sur la base de la première LED (111) du sous-pixel émettant de la lumière lorsqu'une tension nulle est appliquée à la première LED (111), le plot de grille correspondant à la première LED (111) est configuré pour se connecter au plot de source (237) par soudage au laser, et le plot de source (237) est configuré pour se déconnecter du plot métallique à l'aide d'un faisceau laser.

8. Procédé de réparation d'un module d'affichage, comprenant :
la détection d'un sous-pixel (100R, 100G, 100B) défectueux dans le module d'affichage (1) selon la revendication 1 ;
la connexion d'un plot de grille d'un transistor à couches minces, TFT, (23) correspondant au sous-pixel (100R, 100G, 100B) défectueux détecté à un plot de source (237) ; et
le fait d'empêcher qu'une tension source soit appliquée au plot de source (237) par coupage d'un plot métallique connecté au plot de source (237).

9. Procédé de réparation d'un module d'affichage (1) selon la revendication 8, comprenant en outre le soudage du plot de grille au plot de source (237) à l'aide d'un faisceau laser.

10. Procédé de réparation d'un module d'affichage (1) selon la revendication 8, dans lequel le plot métallique est coupé à l'aide d'un faisceau laser.
